Europäisches Patentamt

European Patent Office

Office européen des brevets

(11) Publication number: **0 151 856**
**B1**

(12) **EUROPEAN PATENT SPECIFICATION**

(45) Date of publication of patent specification: **05.09.90**

(51) Int. Cl.⁵: **G 05 F 1/571, G 05 F 1/46**

(21) Application number: **84306681.2**

(22) Date of filing: **28.09.84**

(54) **Power on-off control circuit.**

(30) Priority: **19.01.84 JP 8322/84**

(43) Date of publication of application:
**21.08.85 Bulletin 85/34**

(45) Publication of the grant of the patent:
**05.09.90 Bulletin 90/36**

(84) Designated Contracting States:
**DE FR GB**

(56) References cited:
**DE-A-1 638 153**
**DE-A-2 813 402**
**FR-A-1 559 911**

**IBM TECHNICAL DISCLOSURE BULLETIN, vol. 25, no. 10, March 1983, page 5195, New York, US; J.F. HOLLOWAY et al.: "Output control of a negative voltage regulator"**

(73) Proprietor: **SHARP KABUSHIKI KAISHA**
**22-22 Nagaike-cho Abeno-ku**
**Osaka 545 (JP)**

(72) Inventor: **Gohda, Ken**
**227-18 Yamamoto-cho**
**Utsunomiya-shi Tochigi-ken (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

The present invention relates to a power ON-OFF control circuit and, more particularly, to a power ON-OFF control circuit for controlling ON-OFF states of a power source such as a relatively small capacity power source which drives an electronic apparatus including a memory.

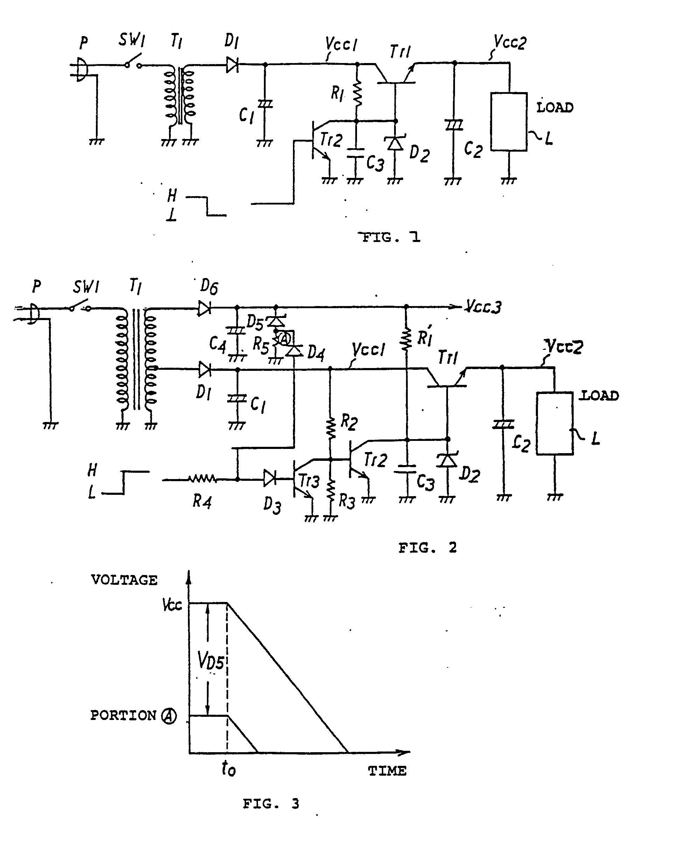

A known power ON-OFF control circuit as shown in FIG. 1 is generally used for controlling ON-OFF states of a power source. The power ON-OFF control circuit of FIG. 1 includes a power transformer T1, a rectifying diode D1, smoothing condensers C1 and C2, a current control transistor Tr1, a Zener diode D2, a resistance R1, a condenser C3, and a switching transistor Tr2.

A series power stabilizing circuit comprises the power transformer T1, the rectifying diode D1, the smoothing condensers C1 and C2, the current control transistor Tr1, the Zener diode D2, the resistance R1, and the condenser C3 all of which operate to stabilize the power from the power source. The switching transistor Tr2 is inserted and connected between the base of the current control transistor Tr1 and ground, and the switching transistor Tr2 operates to control the ON-OFF states of the power source based on the operation of the above power stabilizing circuit.

The power ON-OFF control circuit is connected to an AC (Alternating Current) power source through an AC plug P, and further, connected to a load L to which the power is applied from the AC power source. The power from the AC power source is switched on or off by a main power switch SW1.

The operation of the power ON-OFF control circuit of FIG. 1 will be described below.

When the main power switch SW1 is switched on, an "L" (Low) level control signal is applied to the base of the switching transistor Tr2, so that the switching transistor Tr2 is placed on the OFF state and the current control transistor Tr1 is placed on the ON state. Therefore, an output voltage Vcc1 at the collector of the current control transistor Tr1 is stabilized by the current control transistor Tr1 and transformed into a DC (Direct Current) voltage Vcc2, and the stabilized DC voltage Vcc2 is further applied to the load L.

When the main power switch SW1 is switched off, a "H" (High) level control signal is applied to the base of the switching transistor Tr2, so that the switching transistor Tr2 is placed on the ON state and the current control transistor Tr1 is placed on the cut off sate. Therefore, the output voltage Vcc1 is cut off by the current control transistor Tr1 and the DC voltage Vcc2 is not applied to the load L.

However, if the AC plug P is pulled out when the "L" level control signal is being applied to the base of the switching transistor Tr2, in other words, the main power switch SW1 is still switched on, the DC voltage Vcc2 applied to the load L gradually decreases dependent on the decrease of the rectifying output voltage Vcc1 while the current control transistor Tr1 remains in the ON state. Because the output voltage Vcc1 decreases with small oscillations, the DC voltage Vcc2 gradually decreases with small oscillations, also.

If the load L includes a memory such as a semiconductor memory, the memory may malfunction due to the oscillation of the DC voltage Vcc2, or the contents of the memory may be lost.

It is known from the prior art, for example DE-A-1638153, to provide a voltage regulator without an ON-OFF control but with a shut down function which operates when the input voltage decreases for any reason.

A further prior art document, IBM Technical Disclosure Bulletin, volume 25, No. 10, March 1983, page 5195 describes a power ON-OFF control circuit which has a remote shut down function which uses two transistors acting as diodes operable in response to external control signals.

The present invention aims to provide an improved power ON-OFF control circuit for controlling the ON-OFF states of a power source which drives an electronic apparatus.

According to the invention there is provided a power ON-OFF control circuit comprising:

a power source circuit for deriving a driving voltage from an input voltage;

stabilising means for stabilizing the driving voltage and supplying a stabilized voltage to a load;

first switching means for receiving a switching control signal and operable in accordance with the state of said switching control signal to enable or disable the stabilizing means and thus allow or prevent supply of the stabilized voltage to the load;

wherein said power source circuit is arranged also to derive a reference voltage greater than said driving voltage and there is also provided detecting means for detecting the presence or absence of the reference voltage, and second switching means are operatively connected to the detecting means, and arranged to override the switching control signal so as to disable the stabilizing means in response to the detecting means detecting the absence of the reference voltage when the switching control signal is in a state for enabling said stabilizing means.

In order that the present invention may be better understood a detailed description of an embodiment thereof will be given, by way of example, with reference to the accompanying drawings.

FIG.1 is a circuit diagram of a conventional power ON-OFF control circuit.

FIG.2 is a circuit diagram of a power ON-OFF control circuit according to the present invention; and

FIG. 3 is a graph of a transient voltage characteristic for explaining the operation of the power ON-OFF control circuit of FIG. 2.

A power ON-OFF control circuit of the present invention comprises a power transformer T1, rectifying diodes D1 and D6, smoothing condensers C1, C2, and C4, Zener diodes D2 and D5, a current control transistor Tr1, switching transistors Tr2 and Tr3, resistances R'1, R2, R3, R4 and R5, a diode D3, and a switching diode D4.

The power ON-OFF control circuit is connected to a power source through a plug P and a main power switch SW1, and power from the power source is applied to a load L through the power ON-OFF control circuit.

In the above power ON-OFF control circuit, one end of resistance R'1 is connected to the base of the current control transistor Tr1, and the other end of the resistance R'1 is connected to an output terminal which delivers an output voltage Vcc3 (Vcc3> Vcc1).

The rectifying diodes D1 and D6 are connected to the power transformer T1 so that the output voltage (Vcc1) from the rectifying diode D1 is less than the voltage (Vcc3) from the rectifying diode D6.

The base of the switching transistor Tr2 is connected to the collector of the current control transistor Tr1 through resistance R2, and is grounded through resistance R3. The second switching transistor Tr3 is inserted and connected between the base of the switching transistor Tr2 and ground in such a way that it is in the opposite state to Tr2 at any time, i.e. Tr3 is ON when Tr2 is OFF, and vice versa. To that end Tr3, will be described below as a "reverse switching transistor". The "H" (High) level or "L" (Low) level control signal is applied to the base of the reverse switching transistor Tr3 through resistance R4 and the diode D3. The point of connection between the resistance R4 and the diode D3 is connected to the point A between the Zener diode D5 and the resistance R5 through the switching diode D4. The rectifying diode D6 and the smoothing condenser C4 are provided for outputting the relatively high DC voltage Vcc3.

The operation of the above described power ON-OFF control circuit according to the invention will be described below.

When a "H" level control signal is applied to the base of the reverse switching transistor Tr3 through the resistance R4 and the diode D3 when the main power switch SW1 is switched on and remains in the ON state, the reverse switching transistor Tr3 is placed in the ON state and the electric potential of the base of the switching transistor Tr2 decreases sufficiently for the transistor Tr2 to be placed in the cut-off state. The current control transistor Tr1 is placed in the ON state due to the cut-off state of the switching transistor Tr2. Accordingly, the stabilized DC voltage Vcc2 is produced and is fed to the emitter of the current control transistor Tr1 so that the stabilized DC voltage Vcc2 is applied to the load L.

On the contrary, when an "L" level control signal is applied to the anode of the diode D3 through the resistance R4, the diode D3 and the reverse switching transistor Tr3 are placed in the cut-off state. When the diode D3 and the reverse switching transistor Tr3 are placed on the cut-off state, the voltage at the base of the switching transistor Tr2 is increased, so that the switching transistor Tr2 is switched to the ON state. Therefore, the electrical potential at the base of the current control transistor Tr1 decreases, and the current control transistor Tr1 is placed in the cut-off state. Finally, the supply of the power voltage to the load L is stopped.

In this embodiment, the current control transistor Tr1 is placed in the ON or OFF state according to the "H" or "L" level control signal, respectively, so that the supply of the power voltage to the load L is controlled.

The operation of the power ON-OFF control circuit when plug P is pulled out or the main power switch SW1 is switched off at the same time as the "H" level control signal is being applied to the base of the switching transistor Tr3 through the resistance R4 and the diode D3, will now be described.

If the main power supply is stopped at time t0, output voltages Vcc1 and Vcc3 decrease according to predetermined time constants, respectively. During this time, the electric potential at the connection point A between the Zener diode D5 and the resistance R5 decreases at the same rate as the output voltage Vcc3 as shown in FIG. 3. The switching diode D4 will be placed in the ON state as the voltage at A drops below that between R4 and D3, and the diode D3 and the reverse switching transistor Tr3 are therefore placed in the OFF state. Accordingly, the switching transistor Tr2 is quickly switched to the ON state, and the current control transistor Tr1 is placed in the cut-off state before the voltage Vcc1 has fallen below the DC voltage Vcc2 which is applied to the load L.

As described above, in the above power ON-OFF control circuit, the switching transistors Tr2 and Tr3 are inserted and connected to the base of the current control transistor Tr1 of the power stabilizing circuit, and the current control transistor Tr1 is turned on or off by supplying a "H" or "L" level control signal respectively, to the base of the switching transistor Tr3, so that the supply of the power voltage Vcc2 to the load L is controlled i.e. either stopped or continued. Further, the Zener diode D5 and the resistance R5 operate to detect directly whether the power voltage Vcc3, and hence indirectly whether Vcc1, is being inputted. If the voltages Vcc1 and Vcc3 are not being applied, the transistor Tr3 is placed in the OFF state by the switching on of the switching diode D4, and the transistor Tr2 is placed in the ON state, so that the current control transistor Tr1 is quickly placed in the OFF state.

Therefore, the supply voltage Vcc2 is not applied to the load L when the power voltage Vcc1 decreases and is oscillating. If the power ON-OFF control circuit of the present invention is connected to a load L such as an electronic apparatus including a memory, the contents of the memory are protected from being lost due to voltage changes when the power is turned on or off.

The power ON-OFF control circuit of the present invention may also be applied to a television receiver.

## Claims

1. A power ON-OFF control circuit comprising:
a power source circuit for deriving a driving voltage (Vcc1) from an input voltage;
stabilising means (Tr1, D2) for stabilizing the driving voltage (Vcc1) and supplying a stabilized voltage (Vcc2) to a load (L);
first switching means (Tr2, Tr3) for receiving a switching control signal and operable in accordance with the state of said switching control signal to enable or disable the stabilizing means (Tr1, D2) and thus allow or prevent supply of the stabilized voltage (Vcc2) to the load (L);
characterised in that said power source circuit is arranged also to derive a reference voltage (Vcc3) greater than said driving voltage (Vcc1) and in that there is also provided detecting means (D5, R5) for detecting the presence or absence of the reference voltage (Vcc3), and second switching means (D4) operatively connected to the detecting means (D5, R5) and arranged to override the switching control signal so as to disable the stabilizing means in response to the detecting means (D5, R5) detecting the absence of the reference voltage (Vcc3) when the switching control signal is in a state for enabling said stabilizing means.

2. A power ON-OFF control circuit according to claim 1, characterized in that said second switching means (D4) comprises a switching diode coupled between the input of said first switching means (Tr2, Tr3) and a circuit point (A) at which the voltage level varies in accordance with the power level from the power source circuit, said first switching means disabling said stabilizing means when said switching diode is placed in its ON state.

3. A power ON-OFF control circuit according to claim 2, wherein said circuit point (A) is held at a voltage level which varies in accordance with said reference voltage (Vcc3).

4. A power ON-OFF control circuit according to claim 3, characterized in that said circuit point (A) is the connection point between a series connected Zener diode (D5) and a resistor (R5) coupled between said reference voltage (Vcc3) and ground.

5. A power ON-OFF control circuit according to any preceding claim wherein said stabilizing means comprises a transistor (Tr1) arranged to perform voltage stabilization.

6. A power ON-OFF control circuit according to claim 5, wherein said detecting means and said second switching means are operable to cause said transistor (Tr1) to switch off rapidly when power for the power source ceases.

7. A power ON-OFF control circuit according to claim 5 or claim 6, wherein said transistor (Tr1) is arranged in series between the power source circuit and the stabilized power output (Vcc2).

8. A power ON-OFF control circuit according to any preceding claim wherein said first switching means comprises a switching transistor (Tr2) arranged to be switched between ON and OFF states in accordance with the switching control signal and by the detecting and second switching means, and coupled to enable or disable the stabilizing means according to its said state.

9. A power ON-OFF control circuit according to claim 1 wherein said detecting means includes a series connected Zener diode (D5) and resistor (R5) for providing a voltage indicative of whether power is being received by the stabilizing means.

## Patentansprüche

1. Steuerschaltung zur EIN-AUS-Schaltung einer Stromversorgung mit
einer Stromversorgungsschaltung, die aus einer Eingangsspannung eine Treiberspannung (Vcc1) gewinnt;
einer Stabilisierschaltung (Tr1, D2) zur Stabilisierung der Treiberspannung (Vcc1) und zur Bereitstellung einer stabilisierten Spannung (Vcc2) an eine Last (L);
einer ersten Schalteranordnung (Tr2, Tr3), die ein Schalt-Steuersignal aufnimmt und entsprechend diesem Schalt-Steuersignal die Stabilisierschaltung (Tr1, D2) aktiviert oder deaktiviert und dementsprechend die Durchschaltung der stabilisierten Spannung (Vcc2) auf die Last (L) freigibt oder sperrt;
dadurch gekennzeichnet, daß
die Stromversorgungsschaltung außerdem eine Referenzspannung (Vcc3) liefert, die größer ist als die Treiberspannung (Vcc1),
eine Prüfschaltung (D5, R5) vorgesehen ist, welche das Vorhandensein bzw. Nichtvorhandensein der Bezugsspannung (Vcc3) abfragt,
eine zweite Schalteranordnung (D4), die mit der Prüfschaltung (D5, R5) wirkungsmäßig so verbunden ist, daß das Schalt-Steuersignal überlagert wird, so daß die Stabilisierschaltung in Abhängigkeit von der Prüfschaltung (D5, R5) unwirksam wird, welche das Nichtvorhandensein der Referenzspannung (Vcc3) feststellt, wenn das Schalt-Steuersignal im Aktivierungszustand für die Stabilisierschaltung steht.

2. Steuerschaltung nach Anspruch 1, dadurch gekennzeichnet, daß die zweite Schalteranordnung (D4) eine Schaltdiode aufweist, die zwischen dem Eingang der ersten Schalteranordnung (Tr2, Tr3) und einem Schaltungspunkt (A) angeschlossen ist, an dem der Spannungspegel entsprechend dem Leistungspegel der Stromversorgungsschaltung schwankt und daß die erste Schalteranordnung die Stabilisierschaltung außer Funktion setzt, wenn die Schaltdiode in den Zustand EIN geschaltet wird.

3. Steuerschaltung nach Anspruch 2, dadurch gekennzeichnet, daß der Schaltungspunkt (A) auf einem Spannungspegel gehalten wird, der entsprechend der Referenzspannung (Vcc3) variiert.

4. Steuerschaltung nach Anspruch 3, dadurch gekennzeichnet, daß der Schaltungspunkt (A) der Verbindungspunkt zwischen der Reihenschaltung einer Zener-Diode (D5) und eines Transistors (R5) ist, die zwischen der Referenzspannung (Vcc3) und Masse liegt.

5. Steuerschaltung nach einem der vorstehenden Ansprüche, bei der die Stabilisierschaltung einen die Spannungsstabilisierung bewirkenden Transistor (Tr1) aufweist.

6. Steuerschaltung nach Anspruch 5, bei der die Prüfschaltung und die zweite Schalteranordnung wirkungsmäßig so verbunden sind, daß der Transistor (Tr1) rasch abschaltet, wenn die Stromversorgungsschaltung keine Leistung mehr abgibt.

7. Steuerschaltung nach Anspruch 5 oder 6, bei welcher der Transistor (Tr1) in Serie zwischen der Stromversorgungsschaltung und dem stabilisierten Ausgang (Vcc2) liegt.

8. Steuerschaltung nach einem der vorstehenden Ansprüche, bei der die erste Schalteranordnung einen Schalttransistor (Tr2) aufweist, der entsprechend dem Schalt-Steuersignal und durch Abfrage der zweiten Schalteranordnung zwischen den Schaltzuständen EIN und AUS hin- und hergeschaltet wird und entsprechend dem jeweiligen Schaltzustand die Stabilisierschaltung aktiviert oder deaktiviert.

9. Steuerschaltung nach Anspruch 1, bei der die Prüfschaltung die Reihenschaltung einer Zener-Diode (D5) und eines Widerstands (R5) aufweist zur Bereitstellung einer Spannung, die anzeigt, ob die Stabilisierschaltung unter Strom steht.

**Revendications**

1. Circuit de commande marche-arrêt d'alimentation comprenant:
un circuit de source d'alimentation servant à l'obtention d'une tension de pilotage (Vcc1) à partir d'une tension d'entrée;
des moyens de stabilisation (Tr1, D2) pour stabiliser la tension de pilotage (Vcc1) et fournir une tension stabilisée (Vcc2) à une charge (L);
des premiers moyens de commutation (Tr2, Tr3) pour recevoir un signal de commande de commutation et aptes, en fonction de l'état dudit signal de commande de commutation, à activer ou à désactiver les moyens de stabilisation (Tr1, D2) et de cette manière, à permette ou interdire la fourniture de la tension stabilisée (Vcc2) à la charge (L);
caractérisé en ce que ledit circuit de source d'alimentation est disposé de manière à pouvoir également obtenir une tension de référence (Vcc3) supérieure à ladite tension de pilotage (Vcc1) et en ce qu'il est également prévu des moyens de détection (D5, R5) pour détecter la présence ou l'absence de la tension de référence (Vcc3), et des seconds moyens de commutation (D4) fonctionnellement reliés aux moyens de détection (D5, R5) et disposés de manière à annuler l'effet du signal de commande de commutation afin de désactiver les moyens de stabilisation en réponse à la détection, par les moyens de détection (D5, R5), de l'absence de la tension de référence (Vcc3) lorsque le signal de commande de commutation est dans un état propre à activer lesdits moyens de stabilisation.

2. Circuit de commande marche-arrêt d'alimentation selon la revendication 1, caractérisé en ce que lesdits seconds moyens de commutation (D4) comprennent une diode de commutation reliée entre l'entrée desdits premiers moyens de commutation (Tr2, Tr3) et un point de circuit (A) au niveau duquel le niveau de tension varie en fonction du niveau de l'énergie en provenance du circuit de la source d'alimentation, lesdits premiers moyens de commutation désactivant lesdits moyens stabilisateurs lorsque ladite diode de commutation est mise à l'état MARCHE.

3. Circuit de commande marche-arrêt d'alimentation selon la revendication 2, dans lequel ledit point de circuit (A) est maintenu à un niveau de tension qui varie conformément à ladite tension de référence (Vcc3).

4. Circuit de commande marche-arrêt d'alimentation selon la revendication 3, caractérisé en ce que ledit point de circuit (A) constitue le point de connexion entre une diode Zener (D5) et une résistance (R5) reliées en série entre ladite tension de référence (Vcc3) et la masse.

5. Circuit de commande marche-arrêt d'alimentation selon l'une quelconque des revendications précédentes, dans lequel lesdits moyens stabilisateurs comprennent un transistor (Tr1) disposé de manière à effectuer la stabilisation de tension.

6. Circuit de commande marche-arrêt d'alimentation selon la revendication 5, dans lequel lesdits moyens de détection et lesdits seconds moyens de commutation sont aptes à entraîner la mise à arrêt rapide dudit transistor (Tr1) lorsque l'énergie destinée à la source d'alimentation est interrompue.

7. Circuit de commande marche-arrêt d'alimentation selon la revendication 5 ou la revendication 6, dans lequel ledit transistor (Tr1) est disposé en série entre le circuit de source d'alimentation et la sortie d'alimentation stabilisée (Vcc2).

8. Circuit de commande marche-arrêt d'alimentation selon l'une quelconque des revendications précédentes dans lequel lesdits premiers moyens de commutation comprennent un transistor de commutation (Tr2) disposé de manière à être mis aux états MARCHE et ARRET en fonction du signal de commande de commutation et par les moyens de détection et les seconds moyens de commutation, et couplé de manière à activer ou désactiver les moyens stabilisateurs en fonction de son dit état.

9. Circuit de commande marche-arrêt d'alimentation selon la revendication 1, dans lequel lesdits moyens de détection comprennent une diode Zener (D5) et une résistance (R5) reliées en série, destinées à fournir une tension indiquant si de l'énergie est reçue par les moyens stabilisateurs.

FIG. 1

FIG. 2

FIG. 3